# FASCICULE DE BREVET EUROPEEN

(11) **EP 3 507 838 B1**
(45) Date de publication et mention de la délivrance du brevet: **24.01.2024**
(21) Numéro de dépôt: 17764889.6
(22) Date de dépôt: 29.08.2017
(51) Int. Cl.: H01L 31/18, C23C 16/458, H01L 21/67, H01L 21/683, H01L 21/687

(54) **DISPOSITIF DE TRAITEMENT DE PIÈCES**
VORRICHTUNG ZUR BEHANDLUNG VON TEILEN
DEVICE FOR TREATING PARTS

(30) Priorité: 30.08.2016 FR 1658054
(43) Date de publication de la demande: 10.07.2019
(73) Titulaire: ECM GREENTECH, 38100 Grenoble (FR)
(72) Inventeur: LAZZARELLI, Guy, 34090 Montpellier (FR); SEMMACHE, Bachir, 34090 Montpellier (FR); TRAN, Stéphanie, 34090 Montpellier (FR)
(74) Mandataire: Cabinet Beaumont
(86) Numéro de dépôt international: PCT/FR2017/052298
(87) Numéro de publication internationale: WO 2018/042120

(56) Documents cités:
- CN-A- 102 534 561
- US-A1- 2001 050 054
- US-A1- 2003 132 213
- US-A1- 2003 138 560
- US-A1- 2004 025 786
- US-A1- 2010 068 893
- US-A1- 2010 154 711
- US-A1- 2012 240 857

## Description

La présente demande de brevet revendique la priorité de la demande de brevet français FR16/58054 qui sera considérée comme faisant partie intégrante de la présente description.

### Domaine

La présente demande concerne un dispositif de traitement de pièces, notamment de substrats semiconducteurs destinés à la fabrication de cellules photovoltaïques.

### Exposé de l'art antérieur

Un procédé de fabrication d'une cellule photovoltaïque peut comprendre une étape de dépôt d'une couche isolante électriquement sur une face d'un substrat semiconducteur, notamment un substrat en silicium, par exemple selon un procédé de dépôt chimique en phase vapeur avec assistance par plasma ou PECVD (sigle anglais pour Plasma Enhanced Chemical Vapor Déposition).

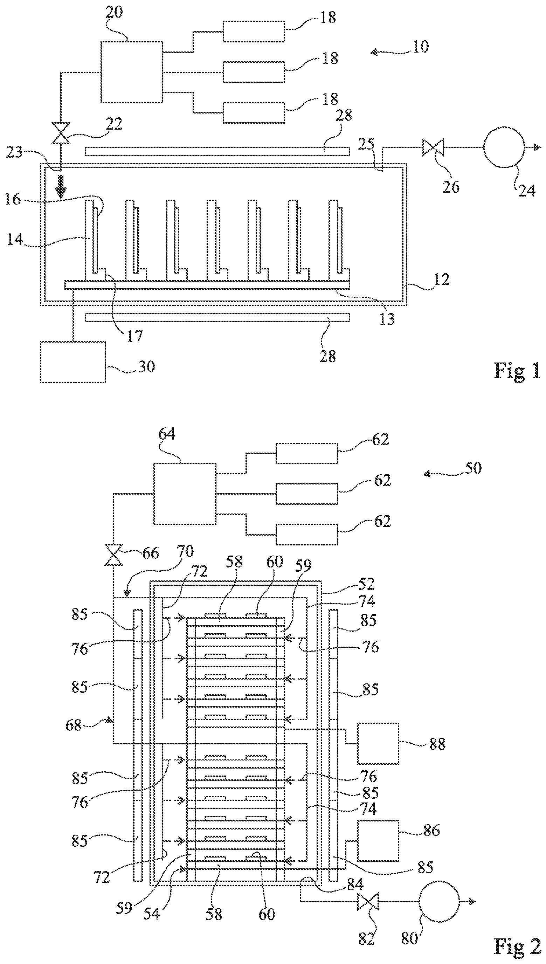

La figure 1 représente, de façon partielle et schématique, un exemple d'un dispositif 10 de traitement de substrats semiconducteurs adapté à la mise en oeuvre d'un procédé PECVD.

Le dispositif 10 comprend une enceinte 12 dans laquelle une pression réduite est maintenue. Le dispositif 10 comprend en outre un support 13 sur lequel sont disposés des plateaux 14. Les plateaux peuvent être introduits dans l'enceinte 12 ou retirés de l'enceinte 12 par une porte, non représentée, par exemple prévue à une extrémité de l'enceinte 12. Chaque plateau 14, par exemple en graphite, peut recevoir au moins un substrat semiconducteur 16. Les substrats semiconducteurs 16 sont disposés sensiblement verticalement dans l'enceinte 12. Chaque plateau 14 comprend au moins un pion 17 pour maintenir le substrat 16 sensiblement plaqué contre une face du plateau 14.

Le dispositif 10 comprend des réservoirs 18 de gaz précurseurs et éventuellement d'un gaz neutre. Les réservoirs 18 sont reliés à un panneau de commande 20 adapté à réaliser un mélange des gaz précurseurs et éventuellement du gaz neutre. Le panneau de commande 20 est relié à l'enceinte 12 par une vanne 22, qui lorsqu'elle est ouverte, permet l'introduction du mélange gazeux dans l'enceinte 12 par une buse d'apport 23. Le dispositif 10 comprend une pompe à vide 24 reliée à l'enceinte 12 par une vanne 26 qui, lorsqu'elle est ouverte, permet l'aspiration du mélange gazeux présent dans l'enceinte 12 par une buse d'aspiration 25.

Le dispositif 10 comprend en outre des éléments chauffants 28 entourant l'enceinte 12 et permettant de commander la température des plateaux 14 et du mélange gazeux dans l'enceinte 12. Le dispositif 10 comprend en outre un générateur 30 d'une tension alternative qui est relié électriquement aux plateaux 14 dans l'enceinte 12.

Le procédé PECVD est une technique de dépôt par voie sèche, c'est-à-dire à partir d'une phase gazeuse. Elle utilise les gaz précurseurs qui sont injectés dans l'enceinte 12 et le dépôt résulte de la décomposition de ces gaz par une réaction chimique à la surface des substrats 16. Dans le procédé PECVD, la réaction chimique est assistée par une décharge électrique radiofréquence (RF) qui ionise les gaz et forme un plasma. Chaque plateau 14 agit comme conducteur thermique et de contact radiofréquence avec le substrat semiconducteur 16 associé. Les plateaux 14 sont reliés au générateur 30 de façon à former une alternance de cathodes et d'anodes et un plasma est généré entre chaque paire de plateaux 14 adjacents. Les gaz précurseurs vont se décomposer pour former un dépôt de couche mince sur la face de chaque substrat 16 opposée à la face au contact avec le plateau 14.

Le dispositif de traitement 10 présente plusieurs inconvénients.

Un inconvénient est que la composition du mélange gazeux à proximité de chaque substrat semiconducteur 16 n'est pas homogène dans l'enceinte 12. En effet, plus on s'éloigne de la buse d'apport 23, plus la proportion des gaz précurseurs ayant déjà réagi augmente. Il peut alors être difficile d'obtenir des dépôts de même épaisseur et de même composition pour chaque substrat semiconducteur 16. Il peut alors être nécessaire de prévoir un écartement variable entre les plateaux 14 pour compenser l'inhomogénéité du mélange gazeux dans l'enceinte 12. Ceci peut rendre complexe la conception du support 13 et/ou la mise en place des plateaux 14 sur le support 13.

Un autre inconvénient est que les substrats semiconducteurs 16 étant disposés verticalement dans l'enceinte 12, ils peuvent subir sous leur propre poids des contraintes mécaniques qui ne sont pas souhaitables.

Un autre inconvénient est qu'il peut ne pas se produire de dépôt sur les zones des substrats semiconducteurs 16 occultées par les pions 17. L'absence de dépôt peut rendre complexes les étapes ultérieures du procédé de fabrication des cellules photovoltaïques. En outre, les zones des substrats semiconducteurs 16 où le dépôt est absent peuvent former des zones fragiles au niveau desquelles des phénomènes de claquage des cellules photovoltaïques peuvent se produire. Le document de l'état de l'art US 2010/068893 A1 décrit un dispositif de dépôt de film, comprenant une enceinte contenant des substrats déposés sur des plateaux horizontaux tournants.

### Résumé

Un objet d'un mode de réalisation vise à pallier tout ou partie des inconvénients des dispositifs de traitement décrits précédemment.

Un autre objet d'un mode de réalisation est d'améliorer l'homogénéité du mélange gazeux dans l'enceinte du dispositif de traitement.

Un autre objet d'un mode de réalisation est de réduire les contraintes mécaniques subies par les substrats semiconducteurs au cours du traitement.

Un autre objet d'un mode de réalisation est d'obtenir le dépôt d'une couche sur la totalité de la face à traiter de chaque substrat semiconducteur.

Ainsi, un mode de réalisation prévoit un dispositif de traitement de substrats semiconducteurs, le dispositif comprenant une enceinte et au moins un circuit d'apport d'un mélange gazeux dans l'enceinte, l'enceinte contenant au moins un support, le support comprenant un empilement de plateaux sur lesquels reposent les substrats semiconducteurs, chaque plateau ayant une face sensiblement horizontale sur laquelle repose au moins l'un des substrats semiconducteurs. Au moins l'un des plateaux comprend au moins un passage pour le mélange gazeux entre le substrat et le plateau. Le dispositif de traitement comprenant, en outre, au moins un générateur d'une tension alternative relié électriquement à plusieurs desdits plateaux.

Selon un mode de réalisation, ledit plateau comprend des premières rainures parallèles s'étendant dans le plateau depuis ladite face et des deuxièmes rainures parallèles s'étendant dans le plateau depuis ladite face et inclinées par rapport aux premières rainures.

Selon un mode de réalisation, ledit plateau comprend des plots en saillie par rapport à ladite face sur lesquels repose le substrat semiconducteur.

Selon un mode de réalisation, au moins deux substrats semiconducteurs reposent sur ledit plateau, la face dudit plateau comprenant des emplacements sur lesquels reposent les substrats et une nervure en saillie par rapport à la face et séparant au moins partiellement les deux emplacements.

Selon un mode de réalisation, la face dudit plateau comprend un évidement sous le substrat et un canal ouvert seulement à ses extrémités reliant l'évidement à l'un des bords latéraux dudit plateau.

Selon un mode de réalisation, le dispositif comprend un circuit d'apport du mélange gazeux dans l'enceinte, le circuit comprenant au moins deux conduites disposées dans l'enceinte de part et d'autre du support, chaque conduite comprenant des ouvertures pour l'apport du mélange gazeux dans l'enceinte.

Selon un mode de réalisation, les conduites s'étendent verticalement.

Selon un mode de réalisation, les diamètres des ouvertures de chaque conduite augmentent d'une extrémité à l'autre de la conduite.

Selon un mode de réalisation, les ouvertures de l'une des conduites sont décalées selon la direction verticale par rapport aux ouvertures de l'autre conduite.

Selon un mode de réalisation, l'empilement comprend une succession de N plateaux, les ouvertures de l'une des conduites étant situées au niveau des plateaux de rang pair et les ouvertures de l'autre conduite étant situées au niveau des plateaux de rang impair.

Selon un mode de réalisation, les plateaux se répartissent en premiers plateaux successifs et en deuxièmes plateaux successifs, le dispositif comprenant en outre un premier circuit d'apport du mélange gazeux dans l'enceinte et un deuxième circuit d'apport du mélange gazeux dans l'enceinte, le premier circuit comprenant au moins deux premières conduites disposées dans l'enceinte de part et d'autre des premiers plateaux et le deuxième circuit comprenant au moins deux deuxièmes conduites disposées dans l'enceinte de part et d'autre des deuxièmes plateaux, chaque première et deuxième conduite comprenant des ouvertures pour l'apport du mélange gazeux dans l'enceinte.

Selon un mode de réalisation, le dispositif comprend un premier générateur d'une première tension alternative relié aux premiers plateaux et un deuxième générateur d'une deuxième tension alternative reliés aux deuxièmes plateaux.

Selon un mode de réalisation, le dispositif comprend une pompe à vide reliée à l'enceinte.

Selon un mode de réalisation, le dispositif est destiné au traitement de substrats semiconducteurs destinés à la fabrication de cellules photovoltaïques.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1, décrite précédemment, représente, de façon partielle et schématique, un exemple de dispositif de traitement PECVD de substrats semiconducteurs ;
la figure 2 représente, de façon partielle et schématique, un mode de réalisation d'un dispositif de traitement PECVD de substrats semiconducteurs ;
la figure 3 est une vue agrandie, partielle et schématique, d'une conduite d'apport d'un mélange gazeux du dispositif de traitement représenté en figure 2 ;
les figures 4A, 4B et 4C sont respectivement une vue de dessus, une vue de côté et une vue de détail d'un mode de réalisation d'un plateau du dispositif de traitement représenté en figure 2 ;
les figures 5A, 5B, 5C et 5D sont respectivement une vue en perspective, une vue de dessus, une vue de côté et une vue de détail de la vue de côté d'un autre mode de réalisation d'un plateau du dispositif de traitement représenté en figure 2 ;
les figures 6A, 6B, 6C, 6D, 6E et 6F sont respectivement une vue en perspective, une vue de dessus, une vue de côté, une vue de détail de la vue de côté, une vue de côté avec coupe et une vue de détail de la vue de côté avec coupe d'un autre mode de réalisation d'un plateau du dispositif de traitement représenté en figure 2 ; et
les figures 7A, 7B, 7C, 7D, 7E et 7F sont respectivement une vue en perspective, une vue de dessus, une vue de côté, une vue de détail de la vue de côté, une vue de côté avec coupe et une vue de détail de la vue de côté avec coupe d'un autre mode de réalisation d'un plateau du dispositif de traitement représenté en figure 2.

### Description détaillée

De mêmes éléments ont été désignés par de mêmes références aux différentes figures et, de plus, les diverses figures ne sont pas tracées à l'échelle. Par souci de clarté, seuls les éléments qui sont utiles à la compréhension des modes de réalisation décrits ont été représentés et sont détaillés. En particulier, les moyens de génération d'un plasma sont bien connus de l'homme du métier et ne sont pas décrits en détail.

Dans la description qui suit, lorsque l'on fait référence à des qualificatifs de position relative, tels que les termes "dessus", "dessous", "supérieur", "inférieur", etc., il est fait référence à la direction verticale. Sauf précision contraire, les expressions "approximativement", "sensiblement", et "de l'ordre de" signifient à 10 % près, de préférence à 5 % près.

La figure 2 représente, de façon partielle et schématique, un mode de réalisation d'un dispositif 50 de traitement de pièces adapté à la mise en oeuvre d'un procédé PECVD.

Le dispositif 50 comprend une enceinte 52 étanche, par exemple en acier inoxydable, orientée verticalement, dans laquelle une pression réduite peut être maintenue. L'enceinte 52 peut avoir une forme sensiblement cylindrique d'axe vertical. Le dispositif 50 comprend, en outre, un support 54, également appelé nacelle, pour substrats semiconducteurs 60, le support 54 comprenant une alternance de plateaux 58 en un matériau conducteur électriquement et d'entretoises 59 en un matériau isolant électriquement. Les plateaux 58 de chaque paire de plateaux 58 adjacents sont séparés par l'une des entretoises 59. Les entretoises 59 sont par exemple en céramique. Chaque plateau 58 conducteur est isolé électriquement des plateaux 58 adjacents par les entretoises 59. Chaque plateau 58, par exemple en graphite, peut recevoir au moins un substrat semiconducteur 60, de préférence au moins deux substrats semiconducteurs, par exemple quatre substrats semiconducteurs. Les substrats semiconducteurs 60 sont disposés sensiblement horizontalement sur les plateaux 58. Selon un mode de réalisation, l'écartement entre les plateaux 58 est sensiblement constant, par exemple compris entre 10 mm et 20 mm. Le nombre de plateaux 58 peut être compris entre 5 et 100. L'épaisseur maximale de chaque plateau 58 est comprise entre 1 mm et 10 mm par exemple de l'ordre de 5 mm. Chaque substrat semiconducteur 60 peut avoir une épaisseur comprise entre 100 µm et 200 pm. Chaque substrat 60 peut, en vue de dessus, avoir une forme sensiblement carrée dont le côté est compris entre 100 mm et 220 mm. A titre de variante, chaque substrat 60 peut, en vue de dessus, avoir une forme carrée ou sensiblement carrée (connue généralement sous les expressions carré plein ou pseudo-carré), rectangulaire ou circulaire.

Le dispositif 50 comprend des moyens, non représentés, de déplacement du support 54, notamment pour l'introduire dans l'enceinte 52 ou pour le sortir de l'enceinte 52. Les moyens de déplacement peuvent comprendre une potence qui peut être reliée au sommet du support 54. A titre de variante, les moyens de déplacement peuvent comprendre un bras articulé. L'enceinte 52 comprend une porte, par exemple située au sommet ou à la base de l'enceinte 52, qui lorsqu'elle est ouverte permet l'introduction ou le retrait du support 54 dans l'enceinte 52. A titre de variante, la porte peut être reliée au support 54 et peut refermer hermétiquement l'enceinte 52 lorsque le support 54 est introduit dans l'enceinte 52.

Le dispositif 50 comprend des réservoirs 62 de gaz précurseurs et éventuellement d'au moins un gaz neutre et éventuellement un système de vaporisation et de régulation de la vapeur pour fournir un gaz précurseur à partir d'un réservoir d'un précurseur liquide. Les réservoirs 62 sont reliés, notamment par l'intermédiaire de régulateurs de débit massique, à un panneau de commande 64 adapté à réaliser un mélange gazeux, contenant des gaz précurseurs et éventuellement au moins un gaz neutre, qui dépend du traitement à réaliser. Le panneau de commande 64 est relié à l'enceinte 52 par une ou plusieurs vannes 66. A titre d'exemple, une seule vanne 66 est représentée en figure 2, qui lorsqu'elle est ouverte, permet l'introduction du mélange gazeux dans l'enceinte 52 par des premier et deuxième circuits d'apport 68 et 70. A titre de variante, certains gaz ou liquides en phase vapeur peuvent être éventuellement régulés et introduits dans la chambre indépendamment d'un mélangeur. Chaque circuit d'apport 68, 70 comprend au moins deux conduites tubulaires 72 et 74, par exemple s'étendant sensiblement verticalement dans l'enceinte 52, les conduites 72, 74 du premier circuit d'apport 68 étant disposées de part et d'autre d'un premier ensemble de plateaux 58 successifs, par exemple situés de la mi-hauteur jusqu'au sommet du support 54, et les conduites 72, 74 du deuxième circuit d'apport 70 étant disposées de part et d'autre d'un deuxième ensemble de plateaux 58 successifs, par exemple situés de la base jusqu'à la mi-hauteur du support 54.

Chaque conduite 72, 74 comprend des ouvertures 76 pour l'introduction du mélange gazeux dans l'enceinte 52. A titre de variante, chaque ouverture 76, ou au moins certaines d'entre elles, peut être remplacée par une buse. Chaque ouverture 76 peut correspondre à un trou formé dans la conduite 72, 74 par un outil de perçage de section droite circulaire. On appelle alors diamètre de l'ouverture 76 le diamètre apparent de l'ouverture 76 lorsqu'elle est vue de face, c'est-à-dire le diamètre de l'outil de perçage utilisé pour former l'ouverture 76. Dans le cas où l'ouverture 76 ne correspond pas, en vue de face, à un disque, on appelle diamètre de l'ouverture 76 le diamètre du disque de même surface que la surface apparente de l'ouverture en vue de face.

Le nombre d'ouvertures 76 par conduite 72, 74, la disposition des ouvertures 76 et les dimensions des ouvertures 76 sont déterminés notamment pour que, en fonctionnement, la composition du mélange gazeux dans l'enceinte 52 soit sensiblement homogène à la fois selon la direction verticale et dans n'importe quel plan horizontal. Selon un mode de réalisation, l'ensemble des conduites 72, 74 comprend autant d'ouvertures 76 que le nombre maximum de plateaux 58 pouvant être introduits dans l'enceinte 52. Les ouvertures/buses 76 peuvent être disposées sur les conduites 72, 74 au niveau des plateaux 58 mis en place dans l'enceinte 52, chaque ouverture 76 étant située en vis-à-vis du bord latéral de l'un des plateaux 58 ou de l'espace situé au-dessus de l'un des plateaux 58. Selon un mode de réalisation, pour chaque circuit 68, 70, les ouvertures 76 prévues sur la conduite 72 sont décalées selon la direction verticale par rapport aux ouvertures 76 prévues sur la conduite 74. Pour chaque paire de premier et deuxième plateaux 58 adjacents, une ouverture 76 est située sur la conduite 72 sensiblement en vis-à-vis du bord latéral du premier plateau 58 ou de l'espace situé au-dessus du premier plateau 58 alors qu'il n'y a pas d'ouverture 76 à ce niveau sur la conduite 74 et une ouverture 76 est située sur la conduite 74 sensiblement en vis-à-vis du bord latéral du deuxième plateau 58 ou de l'espace situé au-dessus du deuxième plateau 58 alors qu'il n'y a pas d'ouverture 76 à ce niveau sur la conduite 72.

Le dispositif 50 peut en outre comprendre au moins une conduite supplémentaire, non représentée, d'apport du ou des gaz précurseurs et/ou du gaz neutre qui débouche dans l'enceinte 52, par exemple au sommet de l'enceinte 52. A titre d'exemple, la conduite supplémentaire forme une boucle disposée au sommet de l'enceinte 52 comprenant plusieurs ouvertures pour l'éjection de gaz dans l'enceinte 52 depuis le sommet de l'enceinte 52. Selon le procédé mis en oeuvre, des gaz peuvent être injectés dans l'enceinte seulement par les conduites 72, 74, seulement par la conduite supplémentaire, ou à la fois par les conduites 72, 74 et la conduite supplémentaire.

Le dispositif 50 comprend une pompe à vide 80 reliée à l'enceinte 52 par une ou plusieurs vannes 82. A titre d'exemple, une seule vanne 82 est représentée en figure 2 qui, lorsqu'elle est ouverte, permet l'aspiration du mélange gazeux présent dans l'enceinte 52 par une buse d'aspiration 84. Selon un mode de réalisation, la buse d'aspiration 84 est située à la base de l'enceinte 52 et les raccordements entre les circuits d'apport 68 et 70 et l'enceinte 52 sont situés au sommet de l'enceinte 52. A titre de variante, la buse d'aspiration 84 peut être située au sommet de l'enceinte 52 et les raccordements entre les circuits d'apport 68 et 70 et l'enceinte 52 peuvent être situés à la base de l'enceinte 52.

Le dispositif 50 comprend en outre au moins des éléments chauffants 85 entourant l'enceinte 52, par exemple des résistances électriques, permettant de commander la température des plateaux 58 et du mélange gazeux dans l'enceinte 52. Selon un mode de réalisation, les éléments chauffants 85 peuvent être commandés indépendamment les uns des autres.

Le dispositif 50 comprend en outre au moins un générateur d'une tension alternative relié aux plateaux 58. Les plateaux 58 sont donc connectés à des plots conducteurs électriquement et reliés électriquement au générateur de la tension alternative, deux plateaux 58 adjacents étant isolés électriquement l'un de l'autre par les entretoises 59. Selon un mode de réalisation, le dispositif 50 comprend des premier et deuxième générateurs 86, 88 d'une tension alternative. Le premier générateur 86 est relié électriquement aux plateaux 58 du premier empilement lorsque ceux-ci sont placés dans l'enceinte 52 et le deuxième générateur 88 est relié électriquement aux plateaux 58 du deuxième empilement lorsque ceux-ci sont placés dans l'enceinte 52.

Selon un mode de réalisation, les ouvertures 76 les plus proches de l'extrémité de l'enceinte 52 opposée à l'extrémité de l'enceinte 52 la plus proche de la buse d'extraction 84 peuvent être de plus grandes dimensions que les autres ouvertures. Ces ouvertures sont appelées ouvertures principales d'injection du mélange gazeux dans l'enceinte 52 tandis que les autres ouvertures 76 sont appelées ouvertures secondaires. Selon un mode de réalisation, les ouvertures 76 ou seulement les ouvertures secondaires sont adaptées à injecter le mélange gazeux dans l'enceinte selon un flux défini par un vecteur vitesse ayant une composante radiale et une composante tangentielle par rapport à l'axe de l'enceinte 52.

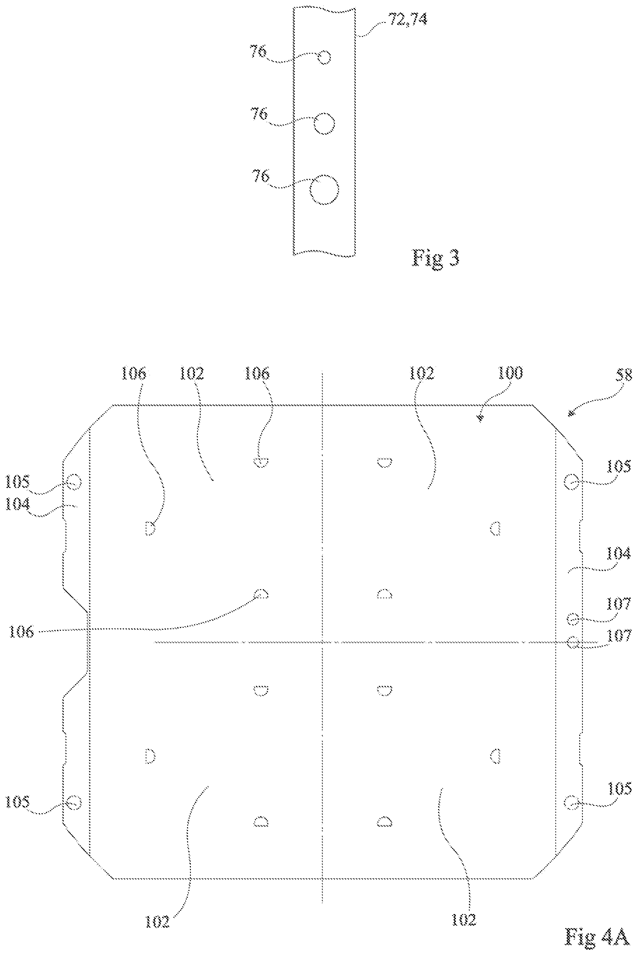

La figure 3 représente un mode de réalisation des ouvertures 76 secondaires dans lequel le diamètre des ouvertures 76 secondaires n'est pas identique. Le diamètre des ouvertures secondaires 76 pour chaque conduite 72, 74 peut croître d'une extrémité à l'autre de la conduite. Lorsque l'arrivée du mélange gazeux dans chaque conduite 72, 74 a lieu par l'extrémité supérieure de la conduite 72, 74, le diamètre des ouvertures 76 pour chaque conduite 72, 74 peut croître du haut vers le bas ou diminuer du haut vers le bas. Selon un mode de réalisation, l'augmentation du diamètre entre l'ouverture la plus proche d'une extrémité de la conduite 72 ou 74 et l'ouverture la plus proche de l'extrémité opposée de la conduite 72 ou 74 est de 100 %.

Le fonctionnement du dispositif 50 va maintenant être décrit dans le cas d'un procédé PECVD.

Le support 54 est monté par assemblage des plateaux 58 et des entretoises 59. Le support 54 peut être utilisé pour plusieurs opérations de dépôt successives. Une opération de maintenance du support 54 peut être prévue après plusieurs opérations de dépôt et comprendre le démontage du support 54 et le nettoyage des plateaux 58.

Les substrats semiconducteurs 60 sont mis en place sur les plateaux 58. Selon un mode de réalisation, la mise en place des substrats 60 sur les plateaux 58 est réalisée en utilisant un préhenseur, par exemple un préhenseur à effet Bernoulli. Les dimensions du préhenseur sont adaptées de façon à permettre l'insertion du préhenseur muni d'un substrat 60 ou de plusieurs substrats 60 dans l'espace présent entre deux plateaux 58 adjacents.

Le support 54 chargé avec les substrats semiconducteurs 60 est ensuite introduit dans l'enceinte 52.

En fonctionnement, le mélange gazeux est introduit dans l'enceinte 52 par chaque ouverture 76 des conduites 72 et 74 de chaque circuit d'apport 68, 70. Chaque plateau 58 agit comme un conducteur thermique et comme un élément de contact radiofréquence avec le substrat semiconducteur 60 ou les substrats semiconducteurs qui reposent sur celui-ci. Les plateaux 58 du premier empilement sont reliés au premier générateur 86 de façon à former une alternance de cathodes et d'anodes et un plasma est généré entre chaque paire de plateaux 58 adjacents du premier empilement. Les plateaux 58 du deuxième empilement sont reliés au deuxième générateur 88 de façon à former une alternance de cathodes et d'anodes et un plasma est généré entre chaque paire de plateaux 58 adjacents du deuxième empilement. La fréquence du plasma commandé par chaque générateur 86, 88 peut être différente ou identique. A titre d'exemple, la fréquence du plasma commandé par chaque générateur 86, 88 est comprise entre 40 kHz et 2,45 GHz, par exemple de l'ordre de 50 KHz. Selon un mode de réalisation, chaque générateur 86, 88 applique la tension alternative aux plateaux associés 58 de façon pulsée, c'est-à-dire en alternant de façon périodique une phase tₒₙ d'application de la tension alternative et une phase t_{off} d'absence d'application de la tension alternative. La période des pulsations peut varier entre 10 ms et 100 ms. Le rapport cyclique des pulsations, c'est-à-dire le rapport entre la durée de la phase tₒₙ et la période des pulsations peut être d'environ 10 %. Selon un mode de réalisation, une phase tₒₙ du générateur 86 a lieu pendant une phase t_{off} du générateur 88 et une phase tₒₙ du générateur 88 a lieu pendant une phase t_{off} du générateur 86. Ce mode de fonctionnement permet de maintenir une distribution des gaz suffisante pour alimenter les deux empilements de plateaux.

Les éléments chauffants 85 peuvent être commandés pour obtenir une température uniforme dans l'enceinte 52 ou pour obtenir un gradient de température dans l'enceinte 52, par exemple selon la direction verticale. Selon le traitement réalisé, la température dans l'enceinte 52 peut être régulée entre 200°C et 600°C.

Selon un mode de réalisation, chaque substrat 60 est un substrat en silicium monocristallin ou polycristallin et le dispositif 50 est utilisé pour le dépôt d'une couche mince, par exemple une couche isolante électriquement, sur la face supérieure de chaque substrat 60. A titre de variante, le dispositif de traitement peut être utilisé pour réaliser des opérations de gravure de substrats semiconducteurs, notamment des opérations de gravure plasma. La couche isolante peut être une couche de nitrure de silicium (SiNₓ), d'oxyde de silicium (SiO_{X}), d'oxynitrure de silicium (SiOₓN_{y}), de carbure de silicium (SiC), de carbonitrure de silicium (SiCN), d'oxyde d'aluminium (AlOₓ), du verre de silicate de bore, du verre de silicate de phosphore, ou du silicium amorphe dopé au bore ou au phosphore ou intrinsèque. Les gaz introduits dans l'enceinte 52 peuvent être choisis dans le groupe comprenant le silane (SiH₄), l'ammoniac (NH₃), le triméthylaluminium (TMA), le protoxyde d'azote (N₂O), le trifluorure d'azote (NF₃), le méthane (CH₄), le trichlorure de bore (BCl₃), du dioxygène (O₂), l'azote (N₂), l'argon (Ar), le diborane (B₂H₆), et la phosphine (PH₃). L'épaisseur de la couche déposée peut être comprise entre 5 nm et 150 nm, de préférence entre 10 nm et 100 nm, par exemple de l'ordre de 40 nm.

La pompe à vide 80 est mise en marche de façon à maintenir une pression dans l'enceinte 52 comprise entre 67 Pa (environ 0,5 Torr) et 667 Pa (environ 5 Torr). Selon un mode de réalisation, la pompe à vide 80 peut fonctionner en continu. Une vanne d'isolation, prévue entre la pompe à vide 80 et la buse 84, permet d'interrompre l'aspiration réalisée par la pompe à vide et une vanne de régulation, prévue entre la pompe à vide 80 et la buse 84, permet de commander la pression dans l'enceinte 52 selon le débit de pompage.

Les gaz précurseurs vont se décomposer pour former un dépôt d'une couche mince sensiblement uniquement sur la face supérieure des substrats 60.

A la fin du traitement, le support 54 est retiré de l'enceinte 52 et les substrats 60 traités sont retirés de chaque plateau 58.

Les substrats 60 étant disposés de façon sensiblement horizontale dans l'enceinte 52, ceci permet de réduire les contraintes mécaniques présentes dans les substrats 60 pendant le traitement par rapport au dispositif de traitement 10 dans lequel les substrats 16 sont disposés de façon sensiblement verticale. En outre, les substrats 60 étant posés sur les plateaux 58, il n'y a pas d'éléments des plateaux 58 qui recouvrent partiellement la surface supérieure de chaque substrat 60. De ce fait, la totalité de la surface supérieure de chaque substrat 60 est exposée au mélange gazeux introduit dans l'enceinte 52. Le dépôt d'une couche d'épaisseur sensiblement uniforme peut alors être réalisé sur la totalité de la surface supérieure de chaque substrat 60.

Le fait de prévoir plusieurs ouvertures 76 réparties selon la direction verticale permet d'augmenter l'homogénéité de la composition du mélange gazeux dans l'enceinte 52 selon la direction verticale.

Le fait de prévoir des ouvertures 76 de part et d'autre des substrats 60 permet d'augmenter l'homogénéité de la composition du mélange gazeux dans l'enceinte 52 selon la direction horizontale. Le nombre d'ouvertures 76 par conduite 72, 74, la disposition des ouvertures 76 et les dimensions des ouvertures 76 sont déterminés notamment pour que, en fonctionnement, la composition du mélange gazeux dans l'enceinte 52 soit sensiblement homogène selon la direction verticale.

De façon avantageuse, la distance entre deux plateaux 58 adjacents du support 54 est sensiblement constante. La conception du support 54 est alors simplifiée et la mise en place des substrats semiconducteurs 60 sur les plateaux 58, par exemple de façon automatisée, est également simplifiée.

De façon avantageuse, les ouvertures 76 des conduites 72, 74 sont situées à proximité des plateaux 58. Ceci permet notamment de réduire les dimensions de l'enceinte 52 par rapport aux plateaux 58. Ceci permet la réalisation d'un dispositif 50 adapté au traitement de substrats 60 de grandes dimensions tout en présentant un encombrement au sol réduit.

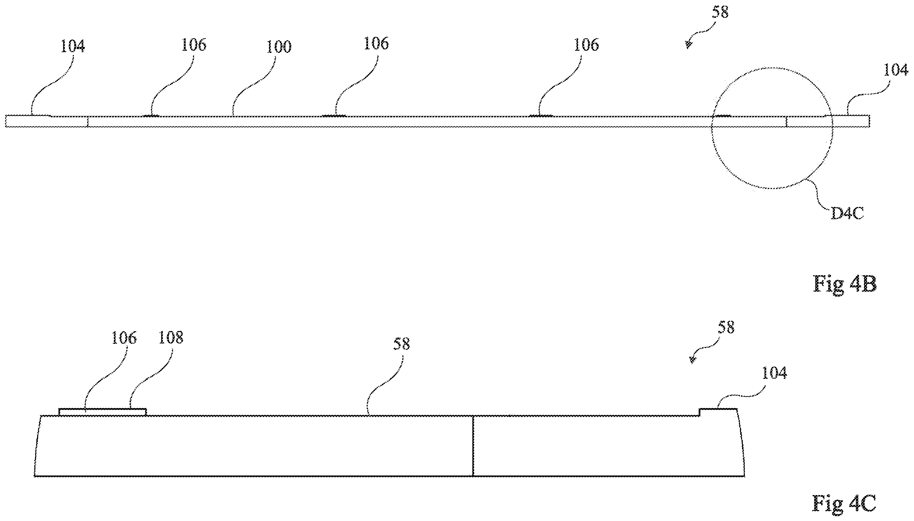

Les figures 4A, 4B et 4C représentent un mode de réalisation d'un plateau 58. La figure 4C est une vue de détail de la figure 4B indiquée par un cercle D4C en figure 4B.

Dans le présent mode de réalisation, le plateau 58 comprend une face supérieure 100 sensiblement plane sur laquelle sont prévus des emplacements 102 pour la pose de quatre substrats 60 non représentés sur les figures 4A à 4C.

Des rebords 104 légèrement en saillie par rapport à la face 100 peuvent être prévus le long de deux bords latéraux opposés du plateau 58. La hauteur de chaque rebord 104 par rapport à la face 100 est comprise entre 0,1 mm et 1 mm, par exemple de l'ordre de 0,5 mm. Des ouvertures 105, débouchant sur la face supérieure 100, peuvent être prévues dans les rebords 104. A titre d'exemple, deux ouvertures 105 sont prévues pour chaque rebord 104. Les ouvertures 105 sont destinées à servir de trous de centrage pour les entretoises 59 isolantes, non représentées sur les figures 4A à 4C, qui séparent le plateau 58 des plateaux adjacents. En outre, des ouvertures 107 peuvent être prévues sur l'un des rebords 104. A titre d'exemple, deux ouvertures 107 sont prévues au milieu du rebord 104. Les ouvertures 107 sont destinées à recevoir les extrémités de connecteurs électriques, non représentés sur les figures 4A à 4C, qui relient électriquement le plateau 58 au générateur de tension alternative 86 ou 88.

Pour chaque emplacement 102, le plateau 58 comprend plusieurs plots 106, par exemple trois plots 106, qui se projettent en saillie par rapport à la face 100, sur une hauteur par exemple comprise entre 0,1 mm et 1 mm, par exemple de l'ordre de 0,5 mm. Chaque plot 106 a un sommet 108 plan parallèle à la face 100. Chaque substrat 60 repose sur les sommets 108 de trois plots 106. Chaque plot 106 peut avoir une section droite correspondant à un segment circulaire dont la surface est légèrement supérieure à la moitié d'un disque. Pour chaque emplacement 102, les trois plots 106 peuvent être répartis aux sommets d'un triangle équilatéral.

Le présent mode de réalisation permet de façon avantageuse la préhension de chaque substrat 60 par un préhenseur à effet Bernoulli. Un préhenseur à effet Bernoulli comprend une tête qui projette de l'air comprimé s'échappant à grande vitesse radialement entre la tête et le substrat 60. Un vide se créé alors entre la tête du préhenseur et le substrat 60. Des éléments de butée maintiennent le substrat 60 à distance afin de permettre l'évacuation de l'air. Par la génération de vide selon le principe de Bernoulli, il est possible de déplacer le substrat 60 presque sans contact. Les plots 106 assurent le maintien d'un film de gaz entre la face supérieure 100 et le substrat 60, ce qui est favorable au bon fonctionnement d'un préhenseur à effet Bernoulli notamment lorsque le substrat 60 est retiré du plateau 58 et évite le risque d'adhésion du substrat 60 sur la face 100 qui pourrait résulter d'un contact direct de surface trop importante entre la face inférieure du substrat 60 et la face 100. Toutefois, l'épaisseur du film de gaz entre le substrat 60 et le plateau 58 est suffisamment faible pour réduire les échanges avec le mélange gazeux introduit dans l'enceinte 52 au cours du traitement. Ceci permet de réduire, voire d'éviter, la formation d'un dépôt sur une partie de la face inférieure de chaque substrat semiconducteur 60 orientée du côté du plateau 58, ce qui n'est pas souhaitable notamment dans le cas où un traitement de chaque face du substrat 60 est prévu.

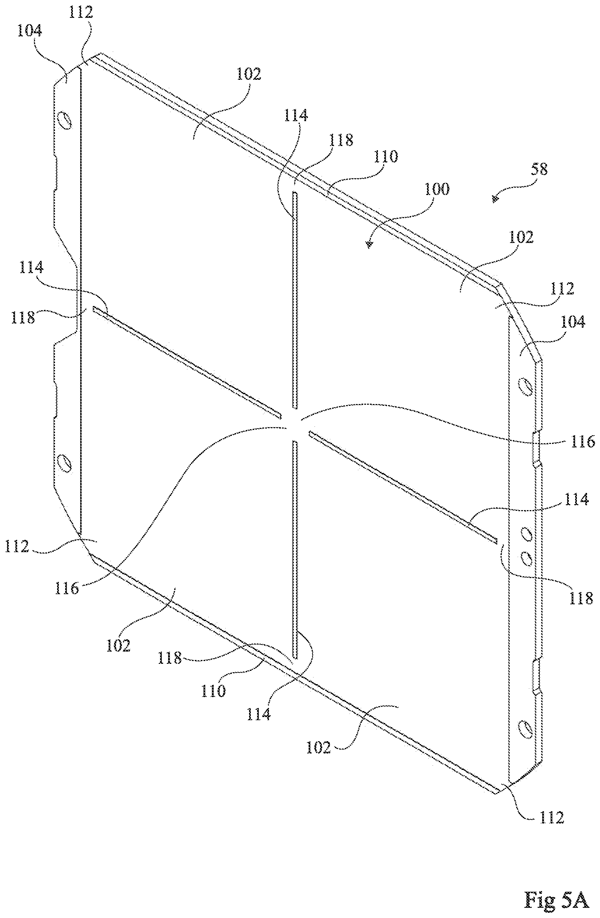

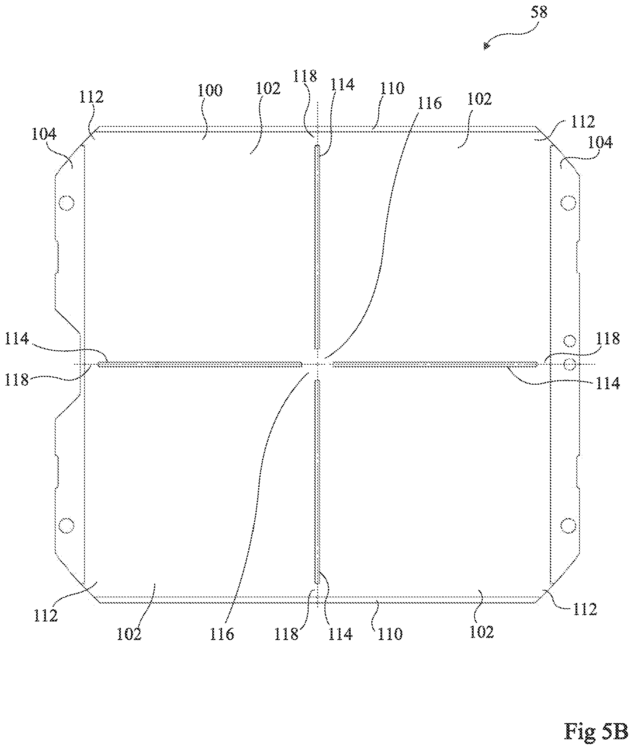

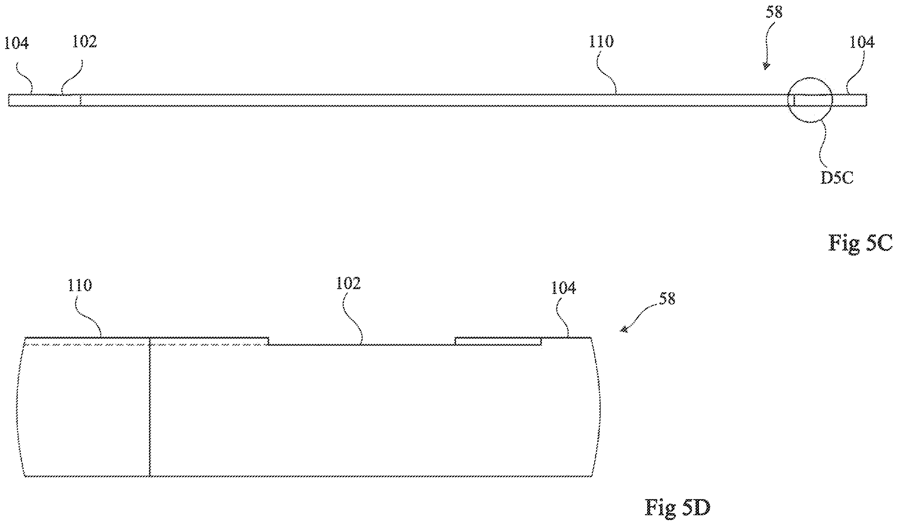

Les figures 5A, 5B, 5C et 5D représentent un autre mode de réalisation d'un plateau 58. La figure 5D est une vue de détail de la figure 5C indiquée par un cercle D5D en figure 5C.

Le plateau 58 représenté sur les figures 5A à 5D comprend l'ensemble des éléments du plateau représenté sur les figures 4A à 4C à la différence que les plots 106 ne sont pas présents et que le plateau 58 représenté sur les figures 5A à 5D comprend, en plus des rebords 104, deux rebords 110 légèrement en saillie par rapport à la face 100 le long des deux autres bords latéraux opposés du plateau 58. Les rebords 104 et 110 ne sont pas jointifs et délimitent des passages 112 aux quatre coins du plateau 58.

Le plateau 58 représenté sur les figures 5A à 5D comprend, en outre, des nervures 114 qui se projettent en saillie par rapport à la face 100, sur une hauteur par exemple comprise entre 0,15 mm et 1 mm, par exemple de l'ordre de 0,25 mm. Les nervures 114 sont rectilignes et délimitent les emplacements 102. Dans le mode de réalisation représenté sur les figures 5A à 5D, le plateau 58 comprend quatre emplacements 102 et quatre nervures 114 disposées selon les branches d'une croix, deux nervures 114 étant alignées selon une première direction et les deux autres nervures 114 étant alignées selon une deuxième direction perpendiculaire à la première direction. Les nervures 114 ne sont pas jointives entre elles ni avec les rebords 104 et 110 de sorte qu'elles délimitent des passages 116 entre elles et des passages 118 avec les rebords 104 et 110. La longueur de chaque nervure 114 peut être comprise entre 5 % et 95 % de la moitié de la distance séparant deux rebords 104 ou 110 opposés. Dans le mode de réalisation représenté sur les figures 5A à 5D, la longueur de chaque nervure 114 est de l'ordre de 90 % de la moitié de la distance séparant deux rebords 104 ou 110 opposés. Toutefois, la longueur des nervures 114 peut être inférieure à ce qui est représenté sur les figures 5A à 5D. A titre de variante, chaque nervure 114 peut être divisée en au moins deux sous-nervures non jointives et alignées.

En fonctionnement, chaque substrat 60 repose sur la portion de la face 100 de l'un des emplacements 102 et le déplacement latéral du substrat 60 dans un plan horizontal est bloqué par les nervures 114 et les rebords 104 et 110. Les nervures 114 et les rebords 104 et 110 du présent mode de réalisation permettent d'éviter un glissement selon une direction horizontale du substrat 60 sur le plateau 58 lorsque le substrat 60 est posé sur le plateau 60. Les passages 112, 116, 118 permettent la circulation de gaz favorable au bon fonctionnement d'un préhenseur à effet Bernoulli.

Le présent mode de réalisation permet en outre de façon avantageuse d'augmenter la surface de contact entre les substrats 60 et le plateau 58 afin d'augmenter l'échange thermique entre les substrats 60 et le plateau 58.

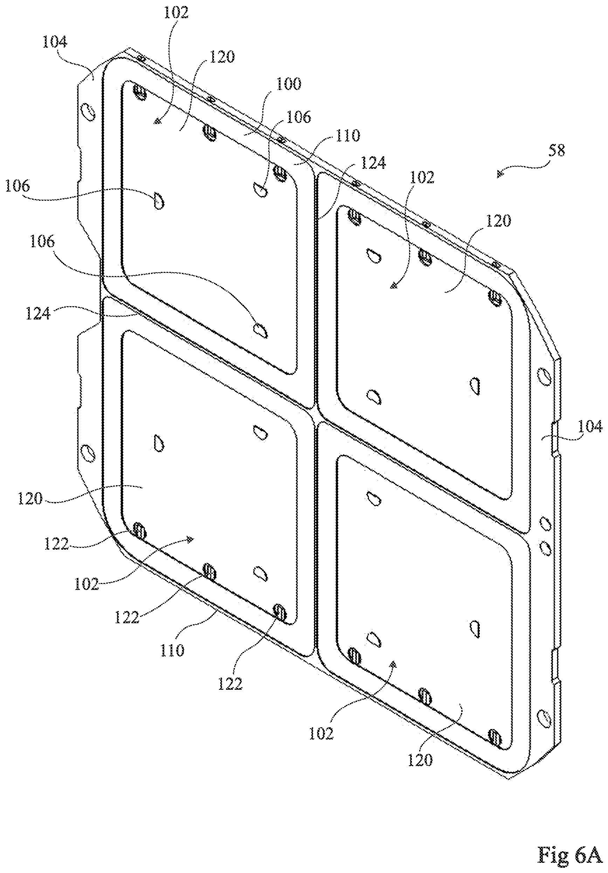

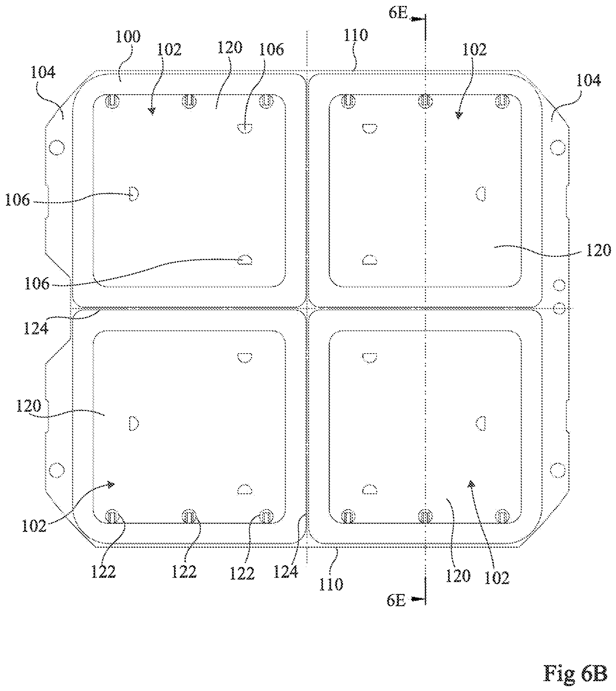

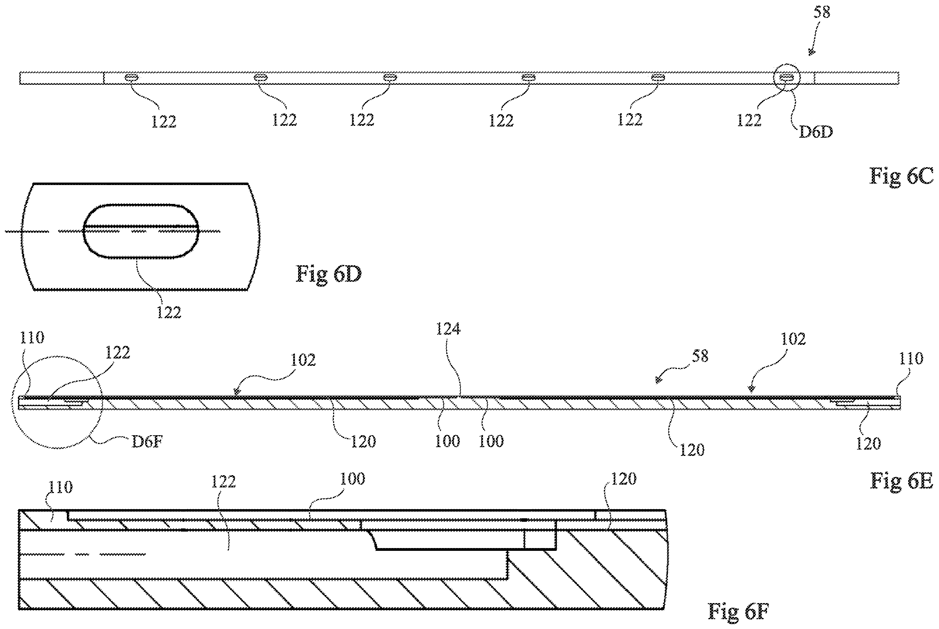

Les figures 6A, 6B, 6C, 6D, 6E et 6F représentent un autre mode de réalisation d'un plateau 58. La figure 6D est une vue de détail de la figure 6C indiquée par un cercle D6D en figure 6C et la figure 6F est une vue de détail de la figure 6E indiquée par un cercle D6F en figure 6E.

Le plateau 58 représenté sur les figures 6A à 6F comprend l'ensemble des éléments du plateau représenté sur les figures 4A à 4C à la différence qu'il comprend pour chaque emplacement 102 un évidement 120 qui s'étend en creux dans la face 100. Chaque évidement 120 a un fond sensiblement plan. La profondeur de chaque évidement 120 par rapport aux sommets des rebords 104 est comprise entre 0,5 mm et 2 mm, par exemple de l'ordre de 1 mm. Les plots 106 se projettent en saillie depuis le fond de chaque évidement 120. Le plateau 58 comprend, pour chaque évidement 120 des canaux 122 pour la circulation de gaz, trois canaux 122 étant représentés pour chaque évidement 120 sur les figures 6A et 6B. Chaque canal 122 débouche à une extrémité sur le fond de l'évidement 120 et débouche à l'extrémité opposée sur l'un des flancs latéraux du plateau 58.

Le plateau représenté sur les figures 6A à 6F comprend en outre, des nervures 124 qui se projettent en saillie par rapport à la face 100, sur une hauteur par exemple comprise entre 0,15 mm et 1 mm, par exemple de l'ordre de 0,5 mm. Les nervures 124 sont rectilignes et délimitent les emplacements 102. Dans le mode de réalisation représenté sur les figures 6A à 6F, le plateau 58 comprend quatre emplacements 102 et quatre nervures 124 disposées selon les branches d'une croix, deux nervures 124 étant alignées selon une première direction et les deux autres nervures 124 étant alignées selon une deuxième direction perpendiculaire à la première direction. Les nervures 124 sont jointives entre elles et avec les rebords 104 et 110.

En fonctionnement, pour chaque emplacement 102, le substrat 60 repose sur la portion de la face 100 de l'un des emplacements 102 entourant l'évidement 120 et sur les plots 106. Le déplacement latéral du substrat 60 dans un plan horizontal est bloqué par les nervures 124 et les rebords 104 et 110. Les nervures 124 et les rebords 104 et 110 du présent mode de réalisation permettent d'éviter un glissement selon une direction horizontale du substrat 60 sur le plateau 58 lorsque le substrat 60 est posé sur le plateau 58. Les canaux 120 permettent la libre circulation de gaz sous le substrat 60, ce qui est favorable au bon fonctionnement d'un préhenseur à effet Bernoulli notamment lorsque le substrat 60 est retiré du plateau 58 et évite le risque d'une adhésion du substrat 60 sur la face 100 qui pourrait résulter d'un contact direct de surface trop importante entre la face inférieure du substrat 60 et la face 100, comme cela peut être le cas avec le plateau 58 représenté sur les figures 5A à 5D.

En outre, lorsque le substrat 60 est en place sur un emplacement 102, le volume de l'évidement 120 communique avec le mélange gazeux présent dans l'enceinte 52 seulement par les canaux 122. Ceci réduit la circulation du mélange gazeux dans l'évidement 120 lors du traitement du substrat 60 et réduit les risques de dépôt indésirable sur la face inférieure du substrat 60.

Le présent mode de réalisation permet en outre de façon avantageuse d'augmenter la surface de contact entre les substrats 60 et le plateau 58 afin d'augmenter l'échange thermique entre les substrats 60 et le plateau 58.

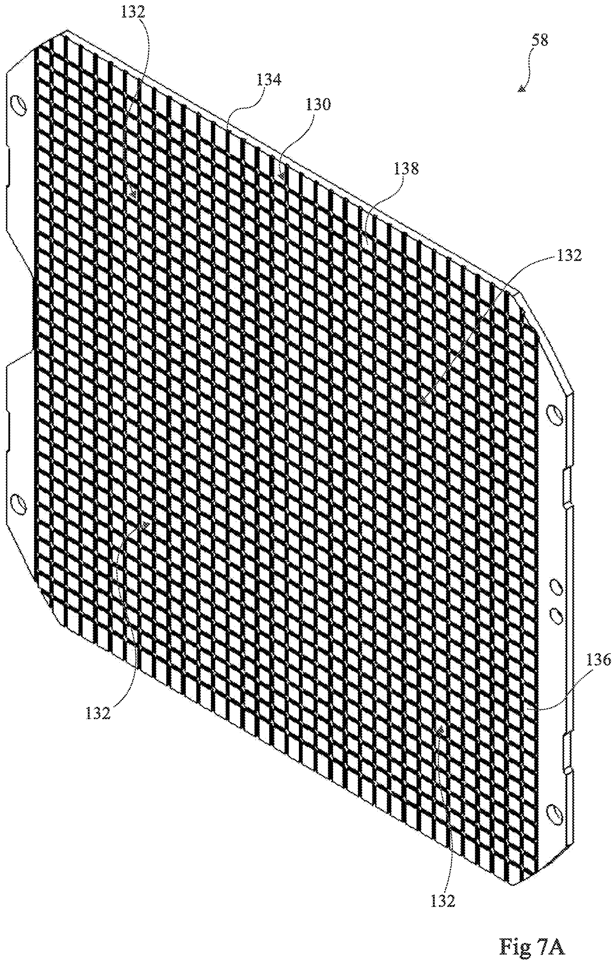

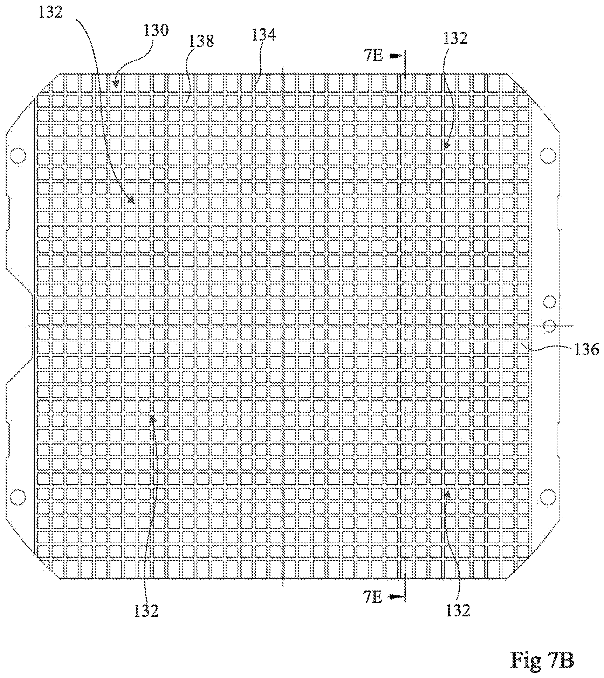

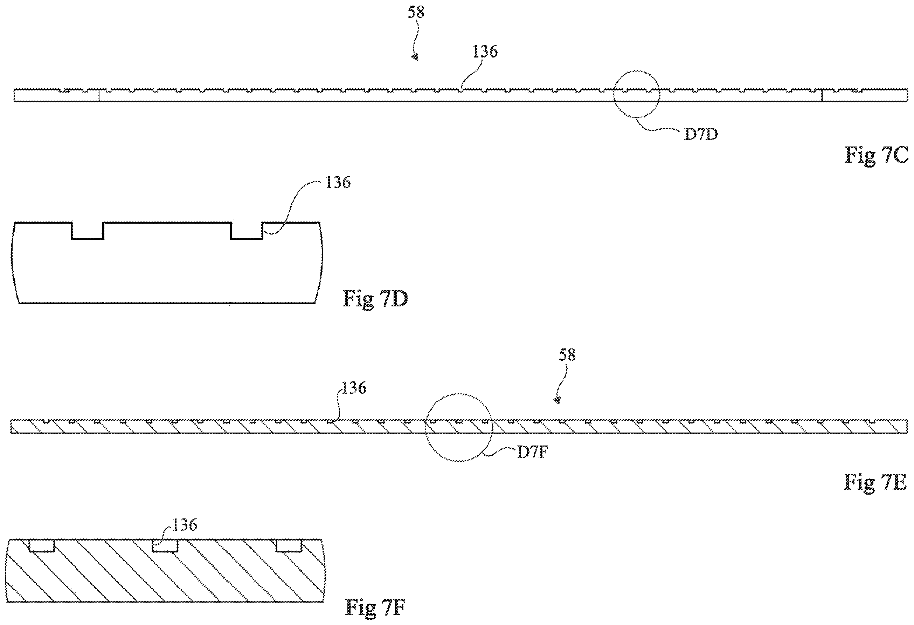

Les figures 7A, 7B, 7C, 7D, 7E et 7F représentent un autre mode de réalisation d'un plateau 58. La figure 7D est une vue de détail de la figure 7C indiquée par un cercle D7D en figure 7C et la figure 7F est une vue de détail de la figure 7E indiquée par un cercle D7F en figure 7E.

Dans le présent mode de réalisation, le plateau 58 comprend une face supérieure 130 sensiblement plane sur laquelle sont prévus des emplacements 132 pour la pose de quatre substrats 60 non représentés sur les figures 7A à 7F. Le plateau 58 représenté sur les figures 7A à 7F comprend, en outre, des premières rainures 134 parallèles qui s'étendent en profondeur dans le plateau 58 depuis la face 130 et qui s'étendent parallèlement à une première direction et des deuxièmes rainures 136 parallèles qui s'étendent en profondeur dans le plateau 58 depuis la face 130 et qui s'étendent parallèlement à une deuxième direction, de préférence perpendiculaire à la première direction. Les rainures 134 et 136 sont réparties selon un quadrillage et divisent la face 102 en portions 138 disjointes. A titre d'exemple, chaque rainure 134, 136 a une profondeur comprise entre 0,5 mm et 3 mm, par exemple de l'ordre de 1 mm et une largeur comprise entre 0,5 mm et 3 mm, par exemple de l'ordre de 2 mm. Le pas de répétition des rainures 134 ou 136 peut être compris entre 5 mm et 40 mm, par exemple de l'ordre de 10 mm.

En fonctionnement, pour chaque emplacement 102, le substrat 60 repose sur les portions 138 de la face 130 associées à l'emplacement 132 correspondant. Les rainures 134 et 136 permettent la libre circulation de gaz sous le substrat 60, ce qui est favorable au bon fonctionnement d'un préhenseur à effet Bernoulli notamment lorsque le substrat 60 est retiré du plateau 58 et évite le risque d'une adhésion du substrat 60 sur la face 130 qui pourrait résulter d'un contact de surface trop importante entre la face arrière du substrat 60 et la face 130, comme cela peut être le cas avec le plateau 58 représenté sur les figures 5A à 5D. En outre, lorsque le substrat 60 est en place sur un emplacement 132, le volume de gaz pris en sandwich entre le substrat 60 et le plateau 58 communique avec l'extérieur seulement par les extrémités des rainures 134, 136. Ceci réduit la circulation du mélange gazeux présent dans l'enceinte 52 lors du traitement du substrat 60 et réduit les risques de dépôts indésirables sur la face arrière du substrat 60.

Le présent mode de réalisation permet en outre de façon avantageuse d'augmenter la surface de contact entre les substrats 60 et le plateau 58 afin d'augmenter l'échange thermique entre les substrats 60 et le plateau 58.

Des modes de réalisation particuliers ont été décrits. Diverses variantes et modifications apparaîtront à l'homme de l'art. En particulier, bien que des exemples de traitement de dépôt de couches minces aient été décrits, le dispositif de traitement peut être utilisé pour réaliser des opérations de gravure de substrats semiconducteurs, notamment des opérations de gravure plasma.

## Revendications

1. Dispositif de traitement (50) de substrats semiconducteurs (60), le dispositif comprenant une enceinte (52) et au moins un circuit (68, 70) d'apport d'un mélange gazeux dans l'enceinte, l'enceinte contenant au moins un support (54), le support comprenant un empilement de plateaux (58) sur lesquels reposent les substrats semiconducteurs, chaque plateau étant en un matériau conducteur électriquement et ayant une face (102 ; 108 ; 130) sensiblement horizontale sur laquelle repose au moins l'un des substrats semiconducteurs, dans lequel au moins l'un des plateaux comprend au moins un passage (112, 116 ; 120, 122 ; 134, 136) pour le mélange gazeux entre le substrat et le plateau, le dispositif de traitement comprenant, en outre, au moins un générateur (86) d'une tension alternative relié électriquement à plusieurs desdits plateaux.

2. Dispositif selon la revendication 1, dans lequel ledit plateau (58) comprend des premières rainures parallèles (134) s'étendant dans le plateau depuis ladite face (132) et des deuxièmes rainures parallèles (136) s'étendant dans le plateau depuis ladite face (132) et inclinées par rapport aux premières rainures.

3. Dispositif selon la revendication 1, dans lequel ledit plateau (58) comprend des plots (106) en saillie par rapport à ladite face (102) sur lesquels repose le substrat semiconducteur (60) .

4. Dispositif selon la revendication 1, dans lequel au moins deux substrats semiconducteurs (60) reposent sur ledit plateau (58), la face (100) dudit plateau comprenant des emplacements (102) sur lesquels reposent les substrats et une nervure (114) en saillie par rapport à la face et séparant au moins partiellement les deux emplacements.

5. Dispositif selon la revendication 3 ou 4, dans lequel la face (102) dudit plateau (58) comprend un évidement (120) sous le substrat (60) et un canal (122) ouvert seulement à ses extrémités reliant l'évidement à l'un des bords latéraux dudit plateau.

6. Dispositif selon l'une quelconque des revendications 1 à 5, comprenant un circuit (68) d'apport du mélange gazeux dans l'enceinte (52), le circuit comprenant au moins deux conduites (72, 74) disposées dans l'enceinte de part et d'autre du support (54), chaque conduite comprenant des ouvertures (76) pour l'apport du mélange gazeux dans l'enceinte.

7. Dispositif selon la revendication 6, dans lequel les conduites (72, 74) s'étendent verticalement.

8. Dispositif selon la revendication 6 ou 7, dans lequel les diamètres des ouvertures (76) de chaque conduite (72, 74) augmentent d'une extrémité à l'autre de la conduite.

9. Dispositif selon l'une quelconque des revendications 6 à 8, dans lequel les ouvertures (76) de l'une des conduites (72) sont décalées selon la direction verticale par rapport aux ouvertures (76) de l'autre conduite (74).

10. Dispositif selon l'une quelconque des revendications 6 à 9, dans lequel l'empilement comprend une succession de N plateaux, les ouvertures (76) de l'une des conduites (72) étant situées au niveau des plateaux de rang pair et les ouvertures (76) de l'autre conduite (72) étant situées au niveau des plateaux de rang impair.

11. Dispositif selon l'une quelconque des revendications 6 à 10, dans lequel les plateaux (58) se répartissent en premiers plateaux (58) successifs et en deuxièmes plateaux (58) successifs, le dispositif comprenant en outre un premier circuit (68) d'apport du mélange gazeux dans l'enceinte et un deuxième circuit (70) d'apport du mélange gazeux dans l'enceinte, le premier circuit comprenant au moins deux premières conduites (72, 74) disposées dans l'enceinte de part et d'autre des premiers plateaux et le deuxième circuit comprenant au moins deux deuxièmes conduites (72, 74) disposées dans l'enceinte de part et d'autre des deuxièmes plateaux, chaque première et deuxième conduite comprenant des ouvertures (76) pour l'apport du mélange gazeux dans l'enceinte.

12. Dispositif selon la revendication 11, comprenant un premier générateur (86) d'une première tension alternative relié aux premiers plateaux (58) et un deuxième générateur (88) d'une deuxième tension alternative reliés aux deuxièmes plateaux.

13. Dispositif selon l'une quelconque des revendications 1 à 12, comprenant une pompe à vide (80) reliée à l'enceinte (52).

14. Dispositif selon l'une quelconque des revendications 1 à 13, pour le traitement de substrats semiconducteurs (60) destinés à la fabrication de cellules photovoltaïques.

## Patentansprüche

1. Vorrichtung (50) zum Behandeln von Halbleitersubstraten (60), wobei die Vorrichtung ein Gehäuse (52) und mindestens eine Zuleitung (68, 70) zum Zuführen eines Gasgemisches in das Gehäuse aufweist, wobei das Gehäuse mindestens einen Träger (54) enthält, wobei der Träger einen Stapel von Platten (58) aufweist, die die Halbleitersubstrate tragen, wobei jede Platte aus einem elektrisch leitenden Material hergestellt ist und eine im Wesentlichen horizontale Oberfläche (102; 108; 130) aufweist, die mindestens eines der Halbleitersubstrate trägt, wobei mindestens eine der Platten mindestens einen Durchgang (112, 116; 120, 122; 134, 136) für das Gasgemisch zwischen dem Substrat und der Platte aufweist, wobei die Behandlungsvorrichtung außerdem mindestens einen Generator (86) für eine Wechselspannung aufweist, der elektrisch mit einer Vielzahl der Platten verbunden ist.

2. Vorrichtung nach Anspruch 1, wobei die Platte (58) erste parallele Nuten (134) aufweist, die sich von der Oberfläche (132) in der Platte erstrecken, und zweite parallele Nuten (136), die sich von der Oberfläche (132) in der Platte erstrecken und in Bezug auf die ersten Nuten geneigt sind.

3. Vorrichtung nach Anspruch 1, wobei die Platte (58) Kontaktflächen (106) aufweist, die von der das Halbleitersubstrat (60) tragenden Oberfläche (102) vorstehen.

4. Vorrichtung nach Anspruch 1, wobei mindestens zwei Halbleitersubstrate (60) auf der Platte (58) aufliegen, wobei die Oberfläche (100) der Platte Stellen (102)aufweisen, die die Substrate tragen, und eine Rippe (114), die bezüglich der Oberfläche vorsteht und die beiden Stellen zumindest teilweise trennt.

5. Vorrichtung nach Anspruch 3 oder 4, wobei die Oberfläche (102) der Platte (58) eine Ausnehmung (120) unter dem Substrat (60) und einen nur an seinen Enden offenen Kanal (122) aufweist, der die Ausnehmung mit einer der Seitenkanten der Platte verbindet.

6. Vorrichtung nach einem der Ansprüche 1 bis 5, aufweisend eine Zuleitung (68) zum Zuführen des Gasgemisches in den Raum (52), wobei die Zuleitung mindestens zwei Leitungen (72, 74) aufweist, die in dem Raum auf beiden Seiten des Trägers (54) angeordnet sind, wobei jede Leitung Öffnungen (76) zum Zuführen des Gasgemisches in das Gehäuse aufweist.

7. Vorrichtung nach Anspruch 6, wobei sich die Leitungen (72, 74) vertikal erstrecken.

8. Vorrichtung nach Anspruch 6 oder 7, wobei die Durchmesser der Öffnungen (76) jeder Leitung (72, 74) von einem Ende der Leitung zum Anderen zunehmen.

9. Vorrichtung nach einem der Ansprüche 6 bis 8, wobei die Öffnungen (76) einer der Leitungen (72) in vertikaler Richtung gegenüber den Öffnungen (76) der anderen Leitung (74) versetzt sind.

10. Vorrichtung nach einem der Ansprüche 6 bis 9, **dadurch gekennzeichnet, dass** der Stapel eine Folge von N Platten aufweist, wobei die Öffnungen (76) einer der Leitungen (72) auf der Höhe der Platten geraden Ranges und die Öffnungen (76) der anderen Leitung (72) auf der Höhe der Platten ungeraden Ranges angeordnet sind.

11. Vorrichtung nach einem der Ansprüche 6 bis 10, wobei die Platten (58) in erste aufeinanderfolgende Platten (58) und in zweite aufeinanderfolgende Platten (58) aufgeteilt sind, wobei die Vorrichtung ferner eine erste Zuleitung (68) zum Zuführen des Gasgemischs in das Gehäuse und eine zweite Zuleitung (70) zum Zuführen des Gasgemischs in das Gehäuse aufweist, wobei die erste Zuleitung mindestens zwei erste Leitungen (72, 74) aufweist, die in dem Gehäuse auf beiden Seiten der ersten Platten angeordnet sind, und die zweite Zuleitung mindestens zwei zweite Leitungen (72, 74) aufweist, die in dem Gehäuse auf beiden Seiten der zweiten Platten angeordnet sind, wobei jede der ersten und zweiten Leitungen Öffnungen (76) zum Zuführen des Gasgemischs in das Gehäuse aufweist.

12. Vorrichtung nach Anspruch 11, aufweisend einen ersten Generator (86) für eine erste Wechselspannung, der mit den ersten Platten (58) verbunden ist, und einen zweiten Generator (88) für eine zweite Wechselspannung, der mit den zweiten Platten verbunden ist.

13. Vorrichtung nach einem der Ansprüche 1 bis 12, aufweisend eine Vakuumpumpe (80), die mit dem Gehäuse (52) verbunden ist.

14. Vorrichtung nach einem der Ansprüche 1 bis 13 zur Behandlung von Halbleitersubstraten (60), die für die Herstellung von Photovoltaik-Zellen bestimmt sind.

## Claims

1. A device (50) for treating semiconductor substrates (60), the device comprising an enclosure (52) and at least one circuit (68, 70) for feeding a gaseous mixture into the enclosure, the enclosure containing at least one support (54), the support comprising a stack of plates (58) supporting the semiconductor substrates, each plate being made of an electrically-conductive material and having a substantially horizontal surface (102; 108; 130) supporting at least one of the semiconductor substrates, wherein at least one of the plates comprises at least one passage (112, 116; 120, 122; 134, 136) for the gaseous mixture between the substrate and the plate, the treatment device further comprising at least one generator (86) of an AC voltage electrically connected to a plurality of said plates.

2. The device of claim 1, wherein said plate (58) comprises first parallel grooves (134) extending across the plate from said surface (132) and second parallel grooves (136) extending across the plate from said surface (132) and inclined with respect to the first grooves.

3. The device of claim 1, wherein said plate (58) comprises pads (106) protruding from said surface (102) supporting the semiconductor substrate (60).

4. The device of claim 1, wherein at least two semiconductor substrates (60) rest on said plate (58), the surface (100) of said plate comprising locations (102) supporting the substrates and a rib (114) protruding from the surface and at least partially separating the two locations.

5. The device of claim 3 or 4, wherein the surface (102) of said plate (58) comprises a recess (120) under the substrate (60) and a channel (122) only open at its ends connecting the recess to one of the lateral edges of said plate.

6. The device of any of claims 1 to 5, comprising a circuit (68) for feeding the gaseous mixture into the enclosure (52), the circuit comprising at least two ducts (72, 74) arranged in the enclosure on either side of the support (54), each duct comprising openings (76) to feed the gaseous mixture into the enclosure.

7. The device of claim 6, wherein the ducts (72, 74) extend vertically.

8. The device of claim 6 or 7, wherein the diameters of the openings (76) of each duct (72, 74) increase from one end to the other of the duct.

9. The device of any of claims 6 to 8, wherein the openings (76) of one of the ducts (72) are offset along the vertical direction with respect to the openings (76) of the other duct (74).

10. The device of any of claims 6 to 9, wherein the stack comprises a succession of N plates, the openings (76) of one of the ducts (72) being located at the level of the plates of even rank and the openings (76) of the other duct (72) being located at the level of the plates of odd rank.

11. The device of any of claims 6 to 10, wherein the plates (58) are distributed in first successive plates (58) and in second successive plates (58), the device further comprising a first circuit (68) for feeding the gaseous mixture into the enclosure and a second circuit (70) for feeding the gaseous mixture into the enclosure, the first circuit comprising at least two first ducts (72, 74) arranged in the enclosure on either side of the first plates and the second circuit comprising at least two second ducts (72, 74) arranged in the enclosure on either side of the second plates, each first and second duct comprising openings (76) to feed the gaseous mixture into the enclosure.

12. The device of claim 11, comprising a first generator (86) of a first AC voltage connected to the first plates (58) and a second generator (88) of a second AC voltage connected to the second plates.

13. The device of any of claims 1 to 12, comprising a vacuum pump (80) connected to the enclosure (52).

14. The device of any of claims 1 to 13, for the treatment of semiconductor substrates (60) intended for photovoltaic cell manufacturing.
